# FASCICULE DE BREVET EUROPEEN

(11) **EP 2 846 424 B1**
(45) Date de publication et mention de la délivrance du brevet: **20.06.2018**
(21) Numéro de dépôt: 13306232.3
(22) Date de dépôt: 09.09.2013
(51) Int. Cl.: H01S 5/022, H01S 5/026, G02F 1/225, G02F 1/015, G02F 1/025, G02F 1/09

(54) **Dispositif optoélectronique intégré comprenant une section d'émission laser et une section de traitement du signal optique émis.**
Integrierte optoelektronische Vorrichtung, die einen Laseremissionsteil und einen Verarbeitungsteil des emittierten optischen Signals umfasst
Integrated optoelectronic device comprising a laser emission section and a section for processing the emitted optical signal

(43) Date de publication de la demande: 11.03.2015
(73) Titulaire: Alcatel Lucent, 91620 Nozay (FR)
(72) Inventeur: Mallecot, Franck, 91460 Marcoussis (FR)
(74) Mandataire: FRKelly

(56) Documents cités:
- US-A- 5 889 607
- US-A1- 2011 233 379
- US-A1- 2011 310 918
- US-B1- 6 373 864
- KOJI YAMADA ET AL: "Design of Double-Pass Electroabsorption Modulators with Low-Voltage, High-Speed Properties for 40 Gb/s Modulation", JOURNAL OF LIGHTWAVE TECHNOLOGY, IEEE SERVICE CENTER, NEW YORK, NY, US, vol. 15, no. 12, 1 décembre 1997 (1997-12-01), XP011029011, ISSN: 0733-8724
- TSUZUKI K ET AL: "Four-channel arrayed polarization independent EA modulator with an IPF carrier operating at 10 Gb/s", IEEE PHOTONICS TECHNOLOGY LETTERS, IEEE SERVICE CENTER, PISCATAWAY, NJ, US, vol. 12, no. 3, 1 mars 2000 (2000-03-01), pages 281-283, XP011431906, ISSN: 1041-1135, DOI: 10.1109/68.826914

## Description

### DOMAINE

La présente invention se rapporte au domaine des dispositifs optoélectroniques, en particulier aux dispositifs optoélectroniques intégrés comportant sur un même support mécanique une section d'émission laser et une section de traitement du signal optique émis par le laser.

### ARRIERE PLAN

L'évolution des réseaux optiques de transport de l'information nécessite une réduction de la taille, du coût et de la consommation énergétique des composants optoélectroniques qu'ils comportent, ainsi que la génération de formats de modulation à forte efficacité spectrale. L'intégration monolithique de diverses fonctions optiques dans un unique circuit photonique intégré PIC (pour « Photonic Integrated Circuit » en anglais) est une réponse pour aller dans ce sens.

Aujourd'hui, les semi-conducteurs de type III-V sur un substrat de phosphure d'Indium InP font partie des matériaux les plus utilisés à partir desquels il est possible de réaliser sur de très petites dimensions (de l'ordre de quelques mm²) un grand nombre de fonctions optiques aussi bien actives (laser, modulateur, amplificateur,...) que passives (guidage, division/recombinaison de faisceaux...) aux longueurs d'onde du réseau de télécommunication avec peu de pertes optiques.

On connait un simple circuit PIC, intégrant sur un support commun une section d'émission laser monofréquence, comme par exemple un laser à rétroaction distribuée DFB (pour « Distributed FeedBack » en anglais), et un modulateur à électroabsorption EAM (pour « ElectroAbsorption Modulator » en anglais) pour moduler le signal optique. C'est un composant optoélectronique disponible sur le marché des télécommunications désigné sous le nom de laser à modulation par électroabsorption EML (pour « Electroabsorption Modulated Laser » en anglais). Un composant EML peut être fabriqué à l'aide des techniques d'intégration monolithique ou hybride. Ce composant dit ILM (pour « Integrated Laser Modulator » en anglais) est très compact, a un faible coût, une faible consommation énergétique et présente de bonnes puissances de sortie, ce qui en fait de bons candidats pour les télécommunications optiques à haut débits (e.g. 40 Gb/s) et courtes distances (e.g. 50 Kms). Toutefois ce composant est complexe à fabriquer et très sensible à la température.

Le besoin existe d'améliorer encore le composant laser intégré modulé IML comme source optique pour les opérations à 50 Gbaud/s utilisant des formats d'amplitude multi-niveau (≥ 2 bits) pour de très courtes distances (< 2 km), voire pour des distances supérieures. Ce perfectionnement est nécessaire en vue de transmissions à haute efficacité spectrale à des vitesses supérieures à 100 Gb/s (50 Gbauds/s avec 2 bits), pour atteindre progressivement 400Gb/s puis 1Tb/s, en utilisant le multiplexage en longueur d'onde (pour « Wavelength Division Multiplexing » en anglais) ou une augmentation du nombre de bits.

Actuellement, il est difficile d'atteindre pour un même composant IML une large bande passante (F-3 dB) associée à un taux d'extinction ER (pour « Extinction Ratio » en anglais) élevé. Le taux d'extinction ER est défini comme le rapport entre l'intensité du signal optique lorsque le modulateur est soumis a une tension électrique de polarisation, appelé état « non passant », et l'intensité du signal optique lorsque le modulateur n'est pas soumis a une tension électrique, appelé « état passant ». Le taux d'extinction ER s'exprime le plus souvent en dB. On appelle taux d'extinction statique SER (pour « Static Extinction Ratio » en anglais), le taux d'extinction obtenu lors de la modulation du signal optique par une tension électrique constante. On appelle taux d'extinction dynamique DER (pour « Dynamic Extinction Ratio » en anglais), le taux d'extinction obtenu lors de la modulation du signal optique par une tension électrique variable. La mesure du taux d'extinction dynamique DER est par exemple effectuée à partir du diagramme de l'oeil. Plus que le taux d'extinction ER, la pente de la courbe représentative du taux d'extinction ER en fonction de la tension électrique appliquée est une des principales caractéristiques dont il faut tenir compte afin d'obtenir une source fonctionnelle, et de diminuer la consommation du circuit électrique de commande en réduisant la tension crête-à-crête qu'il doit délivrer.

La bande passante du modulateur augmente avec la réduction de sa capacité électrique. C'est la raison pour laquelle la longueur des modulateurs pour des applications à haut débit est de plus en plus petite avec l'augmentation du débit des données. L'inconvénient est que la diminution de la longueur du modulateur conduit à une diminution du taux d'extinction ER et une diminution de la pente de la variation du taux d'extinction ER en fonction de la tension appliquée. En conséquence, il est nécessaire d'augmenter la tension appliquée pour obtenir le taux d'extinction dynamique DER souhaité, ce qui est néfastes pour les circuits de commande électroniques. Le taux d'extinction ER, caractéristique importante qu'il est déjà difficile d'atteindre à 40 Gbaud/s, le sera d'autant plus à plus haut débit ou pour des formats multiniveaux (≥ 2 bits).

Une solution consiste à réduire la longueur du modulateur pour atteindre la bande passante souhaitée, et ensuite à compenser la diminution de la pente de la variation du taux d'extinction ER en fonction de la tension appliquée en augmentant le facteur de confinement optique dans les couches actives. Malheureusement, cette approche est limitée par l'effet de saturation optique. La densité de porteurs à l'intérieur de la structure verticale atteint un niveau tel qu'il entraîne une diminution de la bande passante due au transport électronique.

On connait aussi la demande de brevet américaine référence US 2011/233379 A1, le brevet américain référence US 6 373 864 B1 et l'article de Koji Yamada et al. « Design of Double-Pass Electroabsorption Modulators with Low-Voltage, High-Speed Properties for 40Gb/S Modulation » publié dans Journal of Lightwave Technology volume 15 numéro 12 le 1 décembre 1997.

### RESUME

Pour éliminer ces inconvénients, on propose un laser intégré à modulation par électroabsorption EML apte à fonctionner à grande vitesse avec des performances améliorées.

Avantageusement le laser intégré à modulation par électroabsorption EML, comprenant un modulateur à électroabsorption, dont la longueur est adaptée pour couvrir la bande passante en fréquence souhaitée, présente des performances supérieures aux lasers intégrés à modulation par électroabsorption EML connus, sans augmentation du facteur de confinement optique dans les couches actives.

L'objet de la présente invention est un dispositif optoélectronique intégré,
tel que décrit dans la revendication 1, comportant une section d'émission laser émettant un signal optique et une section de traitement du signal émis par la section d'émission laser, dans lequel la section de traitement comporte un miroir optique de manière à réfléchir le signal optique entrant dans la section de traitement par une face d'entrée afin de lui faire effectuer deux fois le même trajet en sens opposés à l'intérieur de la section de traitement de manière à faire ressortir le signal optique réfléchi par la face d'entrée.

On comprend que la section de traitement du signal optique émis par la section d'émission laser fonctionne ici en réflexion, au lieu de fonctionner en transmission comme dans les dispositifs connus.

Selon l'invention, la section d'émission laser et la section de traitement du signal optique sont réalisées de manière monolithique sur un même support.

Selon l'invention, le dispositif comprend en outre un élément de Faraday configuré de manière à imposer une rotation de polarisation au signal optique qui le traverse et un système optique configuré de manière à séparer des signaux optiques de polarisation différente, ledit élément de Faraday et ledit système optique étant situés entre la section d'émission laser et la section de traitement du signal optique.

De préférence, l'élément de Faraday est réalisé de manière hybride, entre la section d'émission laser et la section de traitement du signal optique.

De préférence, le système optique est réalisé de manière hybride, entre la section d'émission laser et la section de traitement.

De préférence, le couplage optique entre la section d'émission laser, le système optique et la section de traitement du signal optique s'effectue en espace libre au moyen de lentilles.

Selon un premier aspect, le dispositif optoélectronique intégré peut comprendre en outre un isolateur optique placé à la sortie de la section d'émission laser.

Selon un deuxième aspect, le dispositif optoélectronique intégré peut comprendre en outre une lame demi-onde placée à l'entrée de la section de traitement.

Selon un troisième aspect, la section de traitement peut comprendre en outre un filtre Fabry-Perrot et deux photodiodes.

Selon un quatrième aspect, le dispositif peut comprendre en outre
- une première lentille placée à la sortie de la section d'émission laser,
- une deuxième lentille placée à l'entrée de la section de traitement du signal optique, et
- une troisième lentille placée à la sortie du système optique vers la fibre optique.

Selon un troisième mode de réalisation, la section d'émission laser est un laser monofréquence à structure en ruban, qui peut être fixe ou accordable.

Selon un quatrième mode de réalisation, la section de traitement du signal optique est choisie parmi un modulateur électro-optique, un amplificateur optique à base de semiconducteur et une matrice optique.

De préférence, la section de traitement du signal optique est un modulateur à électroabsorption fonctionnant en réflexion.

Selon un aspect particulier, la section de traitement du signal optique a une structure en ruban de type hétérostructure semi-isolante enterrée SiBH (pour « Semi-insulating Buried Heterostructure » en anglais).

Pour une longueur donnée, calculée pour atteindre la largeur de bande passante en fréquence spécifiée, le modulateur à électroabsorption en réflexion EAM-R a comme avantage de permettre d'augmenter d'un facteur deux la pente de la courbe de variation du taux d'extinction ER en fonction de la tension V appliquée. Autrement dit, la valeur du taux d'extinction ER (en dB) pour une tension électrique crête-à-crête donnée est multipliée par deux dans le cas de la présente source d'émission laser, par rapport aux sources connues dont le modulateur fonctionne en transmission.

Le modulateur à électroabsorption en réflexion EAM-R a aussi comme avantage de permettre de réduire la contrainte sur le compromis à faire entre la bande passante en fréquence et le taux d'extinction ER du modulateur à électroabsorption en réflexion EAM-R, ce qui constitue actuellement un point de blocage majeur pour le développement des sources optiques à niveaux multiples basées sur des composants optoélectroniques EML. En particulier le modulateur à électroabsorption en réflexion EAM-R doit permettre le développement de sources optiques à fort débit utilisant un nouveau format de modulation, dans le cadre des transmissions à haute efficacité spectrale.

### BREVE DESCRIPTION

D'autres caractéristiques et avantages de la présente invention apparaîtront à la lecture de la description qui suit de modes de réalisation, donnés bien entendu à titre illustratifs et non limitatifs, et dans le dessin annexé sur lequel
- la figure 1 illustre le schéma de principe du fonctionnement d'un modulateur à électroabsorption EAM-R opérant en réflexion,
- la figure 2 illustre la variation du taux d'extinction statique SER en dB en fonction de la tension électrique de polarisation V appliquée à un modulateur à électroabsorption,
- la figure 3 illustre le schéma de principe du fonctionnement d'un dispositif optoélectronique intégré IML comportant une section d'émission laser et une section de traitement du signal optique émis par la section d'émission laser,
- la figure 4 illustre schématiquement un premier mode de réalisation d'un dispositif optoélectronique intégré IML comportant une section d'émission laser et une section de traitement du signal optique émis comprenant un modulateur à électroabsorption en réflexion EAM-R,
- la figure 5 illustre schématiquement un deuxième mode de réalisation d'un dispositif optoélectronique intégré IML dont la section de traitement du signal optique comprend un modulateur à électroabsorption en réflexion EAM-R ,
- la figure 6 illustre schématiquement un troisième mode de réalisation d'un dispositif optoélectronique intégré IML dont la section de traitement du signal optique comprend un modulateur à électroabsorption en réflexion EAM-R,
- la figure 7 illustre schématiquement un quatrième mode de réalisation d'un dispositif optoélectronique intégré IML dont la section de traitement du signal optique comprend un modulateur à électroabsorption en réflexion EAM-R.

### DESCRIPTION DETAILLEE

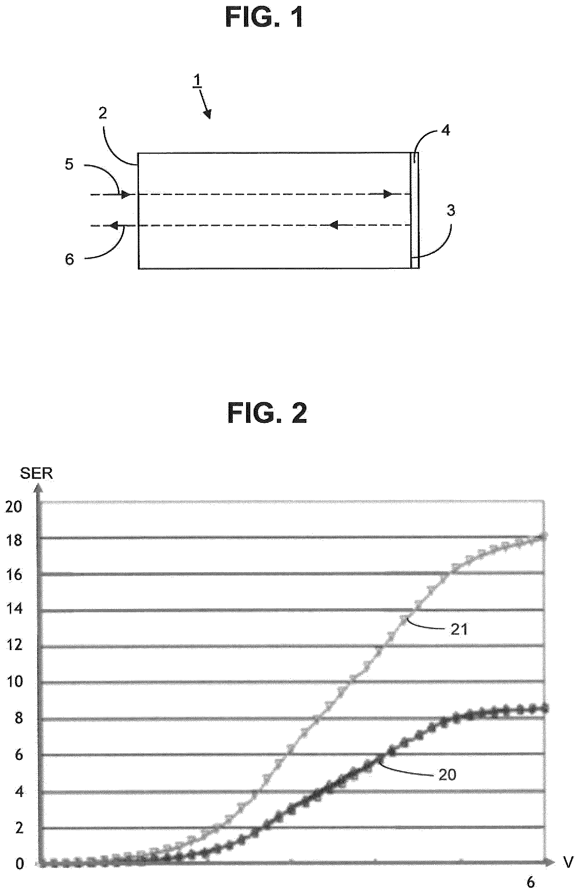

La figure 1 illustre le schéma de principe du fonctionnement d'un modulateur à électroabsorption EAM-R fonctionnant en réflexion.

La modulation d'amplitude par électroabsorption du signal optique entrant repose sur une variation de l'amplitude du signal optique généré par une source laser, qui se traduit par une variation de l'intensité lumineuse du signal sortant. La modulation par électroabsorption est basée sur la modification électriquement induite de la transparence optique du matériau traversé. La modulation est réalisée par l'application d'une tension électrique de polarisation variable modifiant les propriétés d'absorption du matériau. L'intérêt de ce type de modulateur repose sur ses dimensions réduites, sa rapidité qui est compatible avec les systèmes de communications actuels, et son aptitude à être intégré avec un laser dans un composant optoélectronique.

Le modulateur à électroabsorption en réflexion EAM-R **1** comporte une face d'entrée **2** qui reçoit le signal optique à moduler, émis par une source laser, et une face de sortie **3** revêtue d'un matériau réfléchissante **4** tel qu'un dépôt métallique, une structure multicouche à base de TiO₂/SiO₂ ou tout autre moyen permettant la réflexion d'un signal optique (miroir de Bragg,...). Un signal optique entrant **5** traverse le modulateur EAM-R **1** et se réfléchit sur la face réfléchissante **3** pour générer un signal optique sortant **6** qui est modulé en amplitude.

Grâce à cette configuration, le trajet du signal optique **5, 6** à l'intérieur du modulateur à électroabsorption **1** est doublé, ce qui a plusieurs conséquences. Par exemple, la largeur de la bande passante en fréquence peut être augmentée en divisant la longueur du modulateur par un facteur deux, sans pénaliser le taux d'extinction dynamique DER. Ou encore, pour une longueur donnée du modulateur, calculée pour atteindre la bande passante électro-optique spécifiée, la pente de la courbe représentative du taux d'extinction statique SER peut être augmentée d'un facteur deux. Ceci permet de satisfaire à la spécification du taux d'extinction dynamique DER et/ou de diminuer la consommation énergétique du circuit de commande (la tension crête-à-crête est inférieure).

La figure 2 illustre la variation du taux d'extinction statique **SER** (en dB) en fonction de la tension électrique de polarisation **V** appliquée au modulateur à électroabsorption en réflexion EAM-R (en volts) pour une longueur d'onde de λ = 1550 nm.

Le taux d'extinction ER est défini comme le rapport de l'amplitude la plus faible à l'amplitude la plus élevée du signal optique en sortie du composant optoélectronique pour une tension électrique de polarisation **V** donnée appliquée aux bornes du modulateur à électroabsorption EAM-R. Il est habituellement exprimé en dB.

Le résultat expérimental représenté par la courbe **20**, a été obtenu pour un modulateur à électroabsorption EAM ayant une longueur L de 75 µm. Dans ce modulateur EAM connu, le signal optique effectue un seul trajet de longueur L, soit 75 µm. Le taux d'extinction statique **SER** le plus élevé est dans ce cas de l'ordre de -8,5 dB.

Dans un modulateur à électroabsorption en réflexion EAM-R, le signal optique effectue deux trajets, d'abord dans une direction puis dans la direction opposée après réflexion. Le résultat expérimental représenté par la courbe **21**, a été obtenu pour un trajet du signal optique doublé représentant un parcours d'une distance totale de 2L, soit 150 µm. On observe aussi une amélioration très nette du taux d'extinction statique **SER** dans ce cas. Le taux d'extinction statique **SER** le plus élevé est alors de l'ordre de -18 dB, soit une augmentation d'un facteur 2 en dB. En outre la pente de la courbe représentative du taux d'extinction statique SER en fonction de la tension V appliquée a également augmenté d'un facteur 2 en dB/V, ce qui conduit à une plus faible consommation d'énergie dans les circuits électroniques de commande.

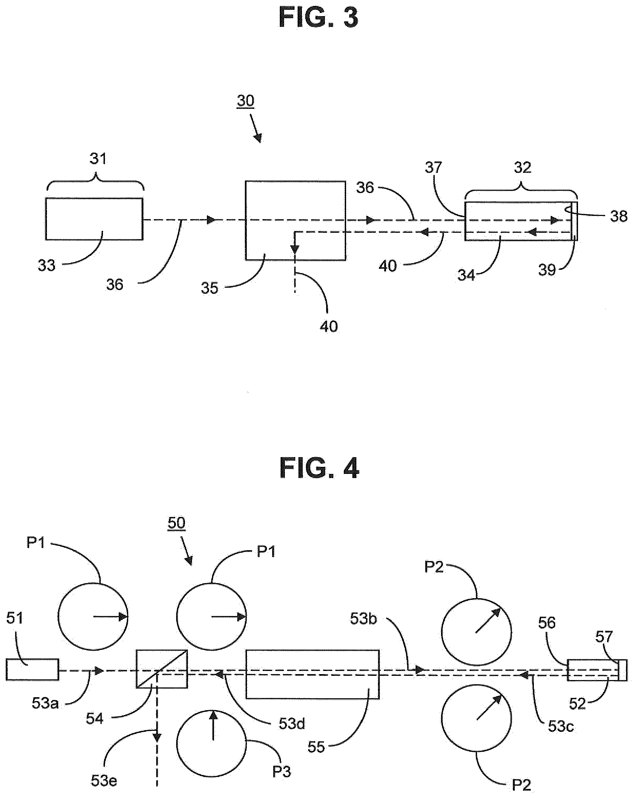

La figure 3 illustre le schéma de principe du fonctionnement d'un dispositif optoélectronique intégré IML **30** comprenant une section d'émission laser **31** et une section de traitement **32** du signal optique par modulation comprenant un modulateur à électroabsorption EAM-R fonctionnant en réflexion.

Le dispositif optoélectronique intégré IML **30** comprend une section d'émission laser **31** et une section de traitement **32**. La section d'émission laser **31** comprend un laser monofréquence **33**, fixe ou accordable, comme par exemple un laser semiconducteur à structure dite à ruban enterré BRS (pour « Buried Ridge Stripe » en anglais), et la section de traitement **32** comprend un modulateur à électroabsorption EAM-R **34** opérant en réflexion, commandé en tout ou rien ou en niveaux multiples, par un signal de tension électrique de polarisation variable.

A près avoir traversé un système optique **35**, apte à séparer des signaux optiques de polarisation différente, le signal optique **36** provenant de la section d'émission laser **31** pénètre dans le modulateur à électroabsorption en réflexion EAM-R **34** par une face d'entrée **37**. Une face **38** du modulateur à électroabsorption en réflexion EAM-R **34**, opposée à la face d'entrée **37** du signal optique **36**, est revêtue d'un matériau réfléchissant **39**. Le signal optique **36** se réfléchi sur la face réfléchissante **38**. Un signal optique réfléchi **40** modulé à haute fréquence est alors envoyé dans la direction inverse, et sort du modulateur à électroabsorption en réflexion EAM-R **34** par la même face d'entrée **37**. A la sortie du modulateur à électroabsorption en réflexion EAM-R **34**, le signal optique réfléchi **40** traverse le système optique **35** séparateur de polarisation dans lequel son trajet est dévié, et le signal optique réfléchi **40** est alors dirigé vers la sortie du dispositif optoélectronique intégré IML **30**.

Cet exemple de réalisation est le fruit d'un mélange de la technologie « Optique en Espace Libre » dite FSO (pour « Free Space Optic » en anglais) et de celle des dispositifs à base d'InP intégrés sur une plate-forme unique par hybridation. En effet la section d'émission laser et la section de traitement du signal optique émis peuvent être réalisée par intégration monolithique sur un même support, mais un système optique séparateur de polarisation performant ne peut être obtenu par cette technique, et on fait alors appel à la technologie d'intégration hybride. Le couplage entre la section d'émission laser et le système optique d'une part et entre le système optique et la section de traitement d'autre part s'effectue en espace libre, i .e. en mode non-guidé. Le dispositif optoélectronique IML obtenu grâce au mélange de ces deux technologies bénéficie des avantages de la haute performance des séparateurs de polarisations optiques réalisés par la technologie FSO (par exemple sur la base de la discrimination de polarisation) combiné à la haute performance et à la compacité des modulateurs intégrés sur un substrat InP. Ce concept peut être étendu à l'intégration monolithique sur un substrat InP, GaAs, SiliconPhotonics ou tout autre substrat approprié, et à tout système optique séparateur de polarisation apte à discriminer les signaux optiques circulant en sens inverse (allant vers et venant du modulateur à électroabsorption en réflexion EAM-R).

On considérera maintenant la figure 4 qui illustre un premier mode de réalisation d'un dispositif optoélectronique intégré IML comportant une section d'émission laser et une section de traitement du signal optique émis comprenant un modulateur à électroabsorption en réflexion EAM-R.

Dans le dispositif optoélectronique IML **50**, la section d'émission laser **51** et la section de traitement **52** sont réalisées monolithiquement sur un support en matériau semiconducteur dopé n, comme par exemple du phosphure d'indium InP. La section de traitement **52** comprend un modulateur à électroabsorption en réflexion EAM-R, et peut comprendre en outre par exemple un filtre Fabry-Perrot et deux photodiodes, permettant de contrôler avec précision la puissance optique et la longueur d'onde émise dans la fibre optique.

Le dispositif optoélectronique intégré IML obtenu bénéficie des avantages des technologies des composants micro-optiques et des composants à base InP. Cette intégration offre un gain de place sur les cartes électro-optiques d'émission (ou circuit photonique intégré PIC) et une réduction du nombre de connexions optiques nécessaires.

Un signal optique **53a** continu émis par la section d'émission laser **51**, ayant une polarisation **P1** transverse électrique TE (pour « Transverse Electric » en anglais), traverse un système optique **54** séparateur de polarisation. Après son passage dans le système optique **54**, la polarisation du signal optique **53a** entrant subit une rotation de 45° grâce à un rotateur optique **55** comportant un élément de Faraday à variation de 45 degrés. Le signal optique **53b** sortant de polarisation **P2**, après rotation de la polarisation, est alors injecté par sa face d'entrée **56** dans la section de traitement **52** comprenant le modulateur à électroabsorption EAM-R fonctionnant en réflexion. Le signal optique **53b** se réfléchit sur la surface réfléchissante **57** opposée à la face d'entrée **56** de la section de traitement **52** comprenant le modulateur EAM-R. Puis le signal optique réfléchi **53c**, ayant conservé la même polarisation **P2** que le signal optique **53b** entrant dans la section de traitement, repart en sens inverse selon le même trajet pour ressortir par la face d'entrée **56** de la section de traitement **52** comprenant le modulateur à électroabsorption en réflexion EAM-R. Le signal optique réfléchi **53c** de polarisation **P2** traverse à nouveau en sens inverse le rotateur optique **55** comportant un élément de Faraday. Le signal optique réfléchi **53c** y subit une rotation de polarisation de 45° qui se cumule avec la rotation précédente. Ces rotations successives conduisent à un signal optique **53d** ayant une polarisation **P3** transverse magnétique TM (pour « Transverse Magnétic » en anglais). Le signal optique réfléchi **53d** de polarisation **P3** est enfin dévié par le système optique **54**, fonctionnant pour le signal optique réfléchi **53d** de polarisation **P3** comme un commutateur de faisceau de polarisation PBS (pour « Polarisation Beam Splitter » en anglais). Le signal optique réfléchi et dévié **53e** de polarisation **P3** est alors dirigé vers la sortie du dispositif optoélectronique intégré IML **50** vers la fibre optique.

Le dispositif optoélectronique intégré IML ainsi obtenu couvre notamment toutes les longueurs d'onde de la bande C ou toutes les longueurs d'onde utilisées pour les applications en télécommunication par exemple. Ce dispositif IML offre une puissance optique de sortie pouvant aller jusqu'à 3 dBm, voire au-delà.

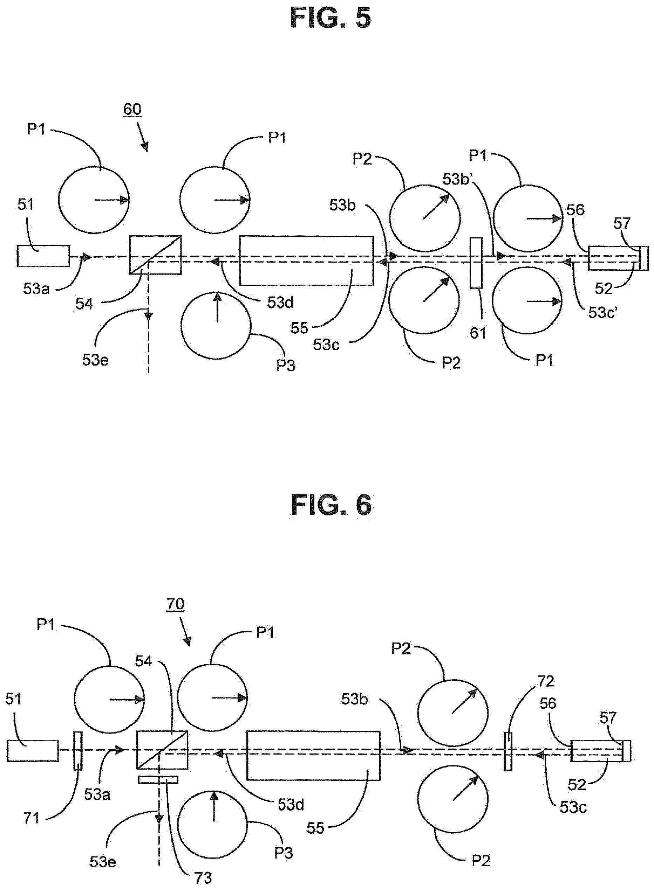

La figure 5 illustre un deuxième mode de réalisation d'un dispositif optoélectronique intégré IML dont la section de traitement du signal optique comprend un modulateur à électroabsorption en réflexion EAM-R. Le dispositif opto-electronique intégré IML **60** comprend en outre une lame demi-onde **61** placée à l'entrée de la section de traitement **52** du signal optique comprenant le modulateur à électroabsorption en réflexion EAM-R. Cette lame demi-onde **61** permet de modifier la polarisation optique afin qu'elle soit toujours orientée suivant l'axe de plus grande efficacité du modulateur à électroabsorption EAM-R fonctionnant en réflexion si les caractéristiques de ce modulateur EAM-R sont dépendantes de la polarisation.

Dans cette variante, le signal optique **53b** de polarisation **P2** issu du rotateur optique **55** est modifié par le passage au travers de la lame demi-onde **61** pour donner un signal optique **53b'** de polarisation **P1** qui est envoyé dans la section de traitement **52**. Le signal **53b'** de polarisation **P1** est réfléchi dans le modulateur EAM-R et un signal optique réfléchi **53c'** de polarisation **P1** ressort de la section de traitement **52** par la face d'entrée **56**. Le signal optique réfléchi **53c'** de polarisation **P1** traverse la lame demi-onde **61** en sens inverse pour ressortir sous la forme d'un signal **53c** de polarisation **P2** à destination du rotateur optique **55**.

Il convient de noter qu'une lame demi-onde pourrait tout aussi bien être aussi disposée à l'entrée de la section de traitement dans les modes de réalisation des figures 4, 6 et 7.

Sur la figure 6, un troisième mode de réalisation d'un dispositif optoélectronique IML **70** est illustré schématiquement. Le couplage optique entre la section d'émission laser **51** et la section de traitement **52** s'effectue en espace libre. Des lentilles fonctionnant en collimation peuvent être ajoutées pour améliorer ce couplage. Le signal optique collimaté peut ainsi être travaillé en insérant, dans le dispositif électro-optique intégré IML **70**, différents composants optiques comme par exemple un séparateur de polarisation, un élément rotateur de Faraday ou des lames demi-ondes (λ/2).

Dans ce mode de réalisation, une première lentille **71** a été ajoutée à la sortie de la section d'émission laser **51**, qui se trouve donc entre la section d'émission laser **51** et le système optique optique **54**. Une deuxième lentille **72** a été placée à l'entrée de la section de traitement **52**, et se trouve donc entre le commutateur optique **55** comportant un rotateur de Faraday et la section de traitement **52** comprenant le modulateur à électroabsorption en réflexion EAM-R. Enfin une troisième lentille **73** a été disposée à la sortie du système optique **54** en direction de la fibre optique. Une lentille supplémentaire peut être aussi prévue à la sortie du système optique 5**4**, entre le système optique optique **54** séparateur de polarisation et le rotateur optique **55**.

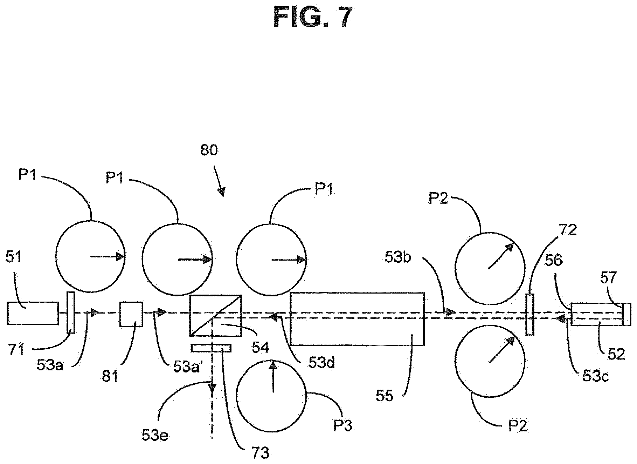

La figure 7 illustre un quatrième mode de réalisation d'un dispositif optoélectronique intégré IML dont la section de traitement du signal optique comprend un modulateur à électroabsorption en réflexion EAM-R. Un dispositif optoélectronique IML **80** comprend en outre un isolateur optique **81** inséré à la sortie de la section d'émission laser **51**. L'isolateur optique **81** permet de garantir la pureté spectrale du signal optique, ce qui constitue un aspect très important dans le domaine des sources laser. De plus cet isolateur optique **81** a comme caractéristique spécifique que les polarisations **P1** du signal optique **53a** à l'entrée et du signal optique **53a'** à la sortie de l'isolateur optique **81** respectivement sont parallèles.

Il convient de noter qu'un isolateur optique pourrait tout aussi bien être aussi disposé à la sortie de la section d'émission laser dans les modes de réalisation des figures 4, 5 et 6.

Bien entendu, la présente invention n'est pas limitée aux modes de réalisation décrits, mais elle est susceptible de nombreuses variantes accessibles à l'homme de l'art sans que l'on s'écarte de l'invention. En particulier, on pourra ajouter différents composants optiques dans le dispositif électro-optique intégré IML comme par exemple un système optique séparateur de polarisation, un élément rotateur de Faraday, des lames demi-ondes (λ/2), un isolateur optique, des lentilles, un filtre Fabry-Perrot et des photodiodes.

## Revendications

1. Dispositif optoélectronique intégré comportant une section d'émission laser émettant un signal optique et une section de traitement du signal émis par la section d'émission laser, dans lequel la section de traitement comporte un miroir optique de manière à réfléchir le signal optique entrant dans la section de traitement par une face d'entrée afin de lui faire effectuer deux fois le même trajet en sens opposés à l'intérieur de la section de traitement de manière à faire ressortir le signal optique réfléchi par la face d'entrée
le dispositif étant **caractérisé en ce que** la section d'émission laser et la section de traitement du signal optique sont réalisées de manière monolithique sur un même support et la section de traitement est un modulateur à électroabsorption fonctionnant en réflexion et
le dispositif comprenant en outre un rotateur optique comprenant un élément de Faraday configuré de manière à imposer une rotation de polarisation au signal optique qui le traverse et un système optique configuré de manière à séparer des signaux optiques de polarisation différente, ledit élément de Faraday et ledit système optique étant situés entre la section d'émission laser et la section de traitement du signal optique.

2. Dispositif selon la revendication 1, dans lequel l'élément de Faraday est réalisé de manière hybride, entre la section d'émission laser et la section de traitement du signal optique.

3. Dispositif selon l'une des revendications 1 et 2, dans lequel le système optique est réalisé de manière hybride, entre la section d'émission laser et la section de traitement du signal optique.

4. Dispositif selon l'une des revendications 1 à 3, dans lequel le couplage optique entre la section d'émission laser, le système optique et la section de traitement du signal optique s'effectue en espace libre au moyen de lentilles.

5. Dispositif selon l'une des revendications 1 à 4, comprenant en outre un isolateur optique placé à la sortie de la section d'émission laser.

6. Dispositif selon l'une des revendications 1 à 5, comprenant en outre une lame demi-onde placée à l'entrée de la section de traitement.

7. Dispositif selon l'une des revendications 1 à 6, comprenant en outre
- une première lentille placée à la sortie de la section d'émission laser,
- une deuxième lentille placée à l'entrée de la section de traitement du signal optique, et
- une troisième lentille placée à la sortie du système optique vers la fibre optique.

8. Dispositif selon l'une des revendications précédentes, dans lequel la section d'émission laser est un laser monofréquence à structure en ruban.

9. Dispositif selon l'une des revendications précédentes, dans lequel la section de traitement du signal optique a une structure en ruban de type hétérostructure semi-isolante enterrée.

## Patentansprüche

1. Integrierte optoelektronische Vorrichtung, die einen Laseremissionsteil, der ein optisches Signal emittiert und einen Verarbeitungsteil des von dem Laseremissionsteil emittierten Signals umfasst, wobei der Verarbeitungsteil einen optischen Spiegel umfasst, um das optische Signal zu reflektieren, das in den Verarbeitungsteil über eine Eintrittsfläche eintritt, damit es im Inneren des Verarbeitungsteils zweimal die gleiche Strecke in entgegengesetzter Richtung zurücklegt, damit das reflektierte optische Signal über die Eintrittsfläche austritt,
wobei die Vorrichtung **dadurch gekennzeichnet ist, dass** der Laseremissionsteil und der Verarbeitungsteil des optischen Signals monolithisch auf einem gleichen Träger umgesetzt sind und dass der Verarbeitungsteil ein Elektroabsorptionsmodulator ist, der durch Reflexion funktioniert und
wobei die Vorrichtung außerdem eine optische Drehvorrichtung umfasst, umfassend ein Faraday-Element, das konfiguriert ist, um dem optischen Signal, das es durchquert, eine Polarisationsdrehung vorzuschreiben und ein optisches System, das konfiguriert ist, um optische Signale mit unterschiedlicher Polarisation zu trennen, wobei sich das Faraday-Element und das optische System zwischen dem Laseremissionsteil und dem Verarbeitungsteil des optischen Signals befinden.

2. Vorrichtung nach Anspruch 1, wobei das Faraday-Element als Hybrid zwischen dem Laseremissionsteil und dem Verarbeitungsteil des optischen Signals umgesetzt wird.

3. Vorrichtung nach einem der Ansprüche 1 und 2, wobei das optische System als Hybrid zwischen dem Laseremissionsteil und dem Verarbeitungsteil des optischen Signals umgesetzt wird.

4. Vorrichtung nach einem der Ansprüche 1 bis 3, wobei die optische Kopplung zwischen dem Laseremissionsteil, dem optischen System und dem Verarbeitungsteil des optischen Signals in einem Freiraum mithilfe von Linsen erfolgt.

5. Vorrichtung nach einem der Ansprüche 1 bis 4, außerdem umfassend einen optischen Isolator, der am Auslass des Laseremissionsteils platziert ist.

6. Vorrichtung nach einem der Ansprüche 1 bis 5, außerdem umfassend ein Halbwellenplättchen, das am Einlass des Verarbeitungsteils platziert ist.

7. Vorrichtung nach einem der Ansprüche 1 bis 6, außerdem umfassend
- eine erste Linse, die am Auslass des Laseremissionsteils platziert ist,
- eine zweite Linse, die am Einlass des Verarbeitungsteils des optischen Signals platziert ist und
- eine dritte Linse, die am Auslass des optischen Systems zu der Glasfaser platziert ist.

8. Vorrichtung nach einem der vorhergehenden Ansprüche, wobei der Laseremissionsteil ein Einzelfrequenzlaser mit einer Bandstruktur ist.

9. Vorrichtung nach einem der vorhergehenden Ansprüche, wobei der Verarbeitungsteil des optischen Signals eine Bandstruktur vom Typ einer halbisolierenden versenkten Heterostruktur aufweist.

## Claims

1. An integrated optoelectronic device comprising a laser emission section that emits an optical signal and a section for processing the signal emitted by the laser emission section, in which the processing section comprises an optical mirror so as to reflect the optical signal entering the processing section through an input face in order to make it perform the same trip twice in opposite directions inside the processing section so as to make the reflected optical signal come out again through the input face,
the device being **characterized in that** the laser emission section and the section for processing the optical signal are produced monolithically on the same support, and the processing section is an electro-absorption modulator operating in reflection mode, and
the device moreover comprising an optical rotator comprising a Faraday element configured so as to impart a polarization rotation on the optical signal which passes through it, and an optical system configured so as to separate optical signals of different polarization, said Faraday element and said optical system being situated between the laser emission section and the section for processing the optical signal.

2. The device according to Claim 1, in which the Faraday element is produced in a hybrid manner, between the laser emission section and the section for processing the optical signal.

3. The device according to either of Claims 1 and 2, in which the optical system is produced in a hybrid manner, between the laser emission section and the section for processing the optical signal.

4. The device according to any one of Claims 1 to 3, in which the optical coupling between the laser emission section, the optical system and the section for processing the optical signal takes place in free-space mode by means of lenses.

5. The device according to any one of Claims 1 to 4, which moreover comprises an optical isolator placed at the output of the laser emission section.

6. The device according to any one of Claims 1 to 5, which moreover comprises a half-wave plate placed at the input of the processing section.

7. The device according to any one of Claims 1 to 6, which moreover comprises
- a first lens placed at the output of the laser emission section,
- a second lens placed at the input of the section for processing the optical signal, and
- a third lens placed at the output of the optical system towards the optical fiber.

8. The device according to any one of the preceding claims, in which the laser emission section is a single-frequency stripe-structure laser.

9. The device according to any one of the preceding claims, in which the section for processing the optical signal has a stripe structure of semi-insulating buried heterostructure type.
